# EUROPÄISCHE PATENTANMELDUNG

(11) **EP 1 437 426 A1**
(43) Veröffentlichungstag der Anmeldung: **14.07.2004**
(21) Anmeldenummer: 03000446.9
(22) Anmeldetag: 10.01.2003
(51) Int. Cl.: C30B 11/00, C30B 29/52

(54) **Verfahren zum Herstellen von einkristallinen Strukturen**

(71) Anmelder: SIEMENS AKTIENGESELLSCHAFT, 80333 München (DE)
(72) Erfinder: Bostanjoglo, Georg, Dr., 12161 Berlin (DE); Krüger, Ursus, Dr., 14098 Berlin (DE); Reiche, Ralph, 13465 Berlin (DE); Steinbach, Jan, 13353 Berlin (DE)

(57) **Zusammenfassung**

Beim epitaktischen Kristallwachstum nach dem Stand der Technik werden oft Strukturfehler eines Substrats übernommen, auf dem das neue Material aufgebracht werden soll. Dies führt zu einer Reduzierung der mechanischen Eigenschaften.

Bei dem erfindungsgemäßen Verfahren wird vor dem epitaktischen Materialauftrag eine Zwischenschicht 10 aufgebracht, die verhindert, dass sich Strukturfehler im Substrat 7 in dem neu ausgefüllten Bereich 13, 16 wiederholen.

## Beschreibung

Die Erfindung bezieht sich auf ein Verfahren zum Herstellen von einkristallinen Strukturen, insbesondere aus Superlegierungen gemäss dem Oberbegriff des Anspruchs 1.

Metallische Werkstücke mit einkristalliner Struktur oder gerichtet erstarrten Strukturen werden als Bauteile von Maschinen verwendet, die im Betrieb hohen mechanischen, thermischen und/oder chemischen Belastungen ausgesetzt sind. Beispielsweise werden Schaufeln von Gasturbinen, insbesondere auch von Rotoren für Flugzeug-Triebwerke, aber auch solche für stationäre Gasturbinen, aus Einkristallen hergestellt. Die Fertigung von derartigen einkristallinen Werkstücken erfolgt z.B. durch gerichtetes Erstarren aus der Schmelze. Es handelt sich dabei um Giessverfahren, bei denen die flüssige metallische Legierung zur einkristallinen Struktur, d.h. zum einkristallinen Werkstück, oder gerichtet erstarrt.
Es ist beispielsweise ein spezielles Giessverfahren zum Herstellen derartiger Werkstücke bekannt, bei dem die in einer keramischen Form befindliche flüssige Legierung in einem gerichteten Temperaturfeld z.B. eines Bridgemanofens eine Kristallorientierung erhält. Dabei werden dendritische Kristalle entlang dem Wärmefluss ausgerichtet und bilden entweder eine stängelkristalline Kornstruktur (d.h. Körner, die über die ganze Länge des Werkstückes verlaufen und hier, dem allgemeinen Sprachgebrauch nach, als gerichtet erstarrt bezeichnet werden) oder eine einkristalline Struktur, d.h. das ganze Werkstück besteht aus einem einzigen Kristall.
In diesen Verfahren muss man den Übergang zur globulitischen (polykristallinen) Erstarrung meiden, bei der sich durch ungerichtetes Wachstum notwendigerweise transversale und longitudinale Korngrenzen ausbilden, welche die guten Eigenschaften des gerichtet erstarrten oder einkristallinen Bauteiles zunichte machen.

Wenn in der vorliegenden Schrift von einkristalliner Struktur und einkristallinen Strukturen die Rede ist, so sind damit sowohl echte Einkristalle, die keine Korngrenzen aufweisen, als auch Kristallstrukturen gemeint, die zwar Korngrenzen, die longitudinal verlaufen, aber keine Korngrenzen, die in transversaler Richtung verlaufen, aufweisen. Bei diesen zweitgenannten kristallinen Strukturen spricht man auch von gerichtet erstarrten Gefügen (directionally solidified structures).

Ist allgemein von gerichtet erstarrten Gefügen die Rede, so sind damit sowohl Einkristalle gemeint, die keine Korngrenzen oder höchstens Kleinwinkelkorngrenzen aufweisen, als auch Stängelkristallstrukturen, die wohl in longitudinaler Richtung verlaufende Korngrenzen, aber keine transversalen Korngrenzen aufweisen.

Als Legierungen beispielsweise für die erwähnten Einkristall-Turbinenschaufeln werden u.a. sog. Superlegierungen auf Nickel- (Ni), Kobalt- (Co) oder Eisenbasis (Fe) verwendet. Besonders Superlegierungen auf Nickelbasis haben hervorragende mechanische und chemische Hochtemperatureigenschaften.

Solche Bauteile nutzen sich im Einsatz ab und werden beschädigt, können aber wieder aufgearbeitet werden, indem man die betroffenen abgenutzten Bereiche falls nötig entfernt und neues Material in diesen Bereichen wieder aufträgt (bspw. epitaktisch). Dabei soll aber wieder die gleiche Kristallstruktur erreicht werden.
Ein solches Verfahren ist in der US-PS 6,024,792 und in der EP 0 892 090 A1 beschrieben. Bei diesem Verfahren wird eine Schicht des aufzutragenden Materials quer zu Länge der zu behandelnden Oberfläche jeweils in Bahnen nebeneinander aufgetragen. Dabei kommt es oft zu Fehlorientierungen, weil in der Nähe der Oberfläche schon nach dem Herstellen und nach Gebrauch nichteinkristalline Strukturen vorhanden sind, die Fehlorientierungen darstellen.

Die Struktur des aufzutragenden Materials orientiert sich aber an der Struktur der Oberfläche, auf der es aufgetragen wird, so dass es zu Fehlorientierungen auch im aufgetragenem Material kommt.
In der Folge sind die mechanischen Eigenschaften in diesem Bereich mangelhaft, wodurch die mechanische Belastbarkeit des gesamten Bauteils beeinträchtigt wird.

Es ist daher Aufgabe der Erfindung, den oben genannten Nachteil zu überwinden.

Die Aufgabe wird gelöst durch ein Verfahren gemäß Anspruch 1, indem auf das Substrat eine Zwischenschicht aufgebracht wird.

Mit dem neuartigen Verfahren ist es möglich, auf der beispielsweise gerichtet erstarrten Struktur eines Substrats eine oder mehrere Schichten, bzw. einen Körper oder ein Werkstück mit der gleichen gerichtet erstarrten Struktur wie das Substrat aufzubauen. Es handelt sich um ein epitaktisches Verfahren (epitaktisch nennt man das gleichorientierte Kristallwachstum auf einer kristallinen Unterlage).
Dabei wird durch eine entsprechende Prozesskontrolle ein globulitisches Gefüge vermieden, was durch Aufbringung einer Zwischenschicht erfolgt.

Die Erfindung schafft ein neuartiges Verfahren, mit dem es möglich ist, auf einem Substrat mit einkristalliner Struktur bzw. einkristallinen Strukturen eine oder mehrere Schichten bzw. einen Körper oder ein Werkstück mit einkristalliner Struktur aufzubauen. Es handelt sich dabei um ein epitaktisches Verfahren, bei welchem die kristalline Struktur des Substrates von der Schicht oder den Schichten, die aufgebaut werden, übernommen wird.

Bisher gab es keine Möglichkeit, ein einkristallines Werkstück so zu reparieren bzw. zu rekonditionieren, dass das einkristalline Gefüge des Grundwerkstoffes auch in der rekonditionierten Stelle vorliegt, ohne dass dabei viele unerwünschte Kristallausrichtungen auftreten.

Mit dem neuen Verfahren ist es nun möglich, beschädigte und abgenutzte einkristalline Werkstücke einkristallin zu rekonditionieren, d.h. die optimale Kristallstruktur zu ergänzen und neu aufzubauen. Dabei wird auf dem Substrat, z.B. bei einer einkristallinen Rotorschaufel, Schicht um Schicht auf einer Bahn einkristallin auf- und weitergebaut bis die ursprüngliche Grösse und Form des Werkstücks wieder erreicht ist.

Das Verfahren für den Aufbau von Einkristallen aus dem gleichen Werkstoff, angenähert gleichen oder auch von dem Substrat verschiedenen Werkstoffen ermöglicht beispielsweise den Neuaufbau bzw. die Ergänzung von Werkstücken, die einkristalline Strukturen aufweisen und die beschädigt sind oder abgenutzt sind. Beispielsweise gibt es heute Rotorschaufeln von Gasturbinen, die aus Einkristallen von sog. metallischen Superlegierungen bestehen und die mit dem Verfahren repariert werden können, wenn sie beschädigt sind.

Einkristalline Werkstücke können zwar aus der Schmelze durch sog. gerichtetes Erstarren (directionally solidified) hergestellt werden. Aber trotz ihrer hervorragenden Eigenschaften nutzen sich auch solche durch gerichtetem Erstarren hergestellten Teile ab.
Mit dem neuen Verfahren ist es nun möglich, beschädigte und abgenutzte einkristalline Werkstücke einkristallin zu rekonditionieren, d.h. die Kristallstruktur zu ergänzen und neu aufzubauen. Dabei wird auf dem Substrat, z.B. bei einer einkristallinen Rotorschaufel, Schicht um Schicht einkristallin auf- und weitergebaut bis die ursprüngliche Grösse und Form des Werkstücks wieder erreicht ist.

Als Energie- bzw. Wärmequelle für das Durchführen des Verfahrens sind Laserstrahlen oder Elektronenstrahlen geeignet, also Energiequellen, mit denen es möglich ist, auf einer grossen Fläche bzw. in einem grossen Volumen hohe Energiemengen einzubringen.

Der Strahl hoher Energie und Energiedichte wird auf die Oberfläche des Substrats gerichtet, so dass eine Oberflächenschicht des Substrats leicht anschmilzt. Dem Arbeitsbereich des Strahls wird das Material bspw. in Pulverform oder in Form eines Drahts zugeführt. Das zugeführte Material wird ebenfalls geschmolzen. Das Schmelzen dieses zugeführten Materials kann im Flüssigbad der geschmolzenen Oberflächenschicht oder schon auf dem Weg zum Flüssigbad erfolgen. Der Vorgang läuft vorzugsweise unter Schutzgas und/oder im Vakuum ab.

Wenn nun das Erstarren der Schmelze unter Bedingungen abläuft, die ausserhalb des globulitischen Bereichs, also im Bereich, in welchem das verwendete Material gerichtet erstarrt, liegt, erstarrt der Werkstoff in einkristalliner Form, wächst also als epitaktische Struktur auf dem Substrat. Bei Metallen spricht man von globulitischer Erstarrung, wenn die Schmelze nicht gerichtet kristallisiert. Es bilden sich dann beim Übergang von "gerichtet einkristallin" auf "ungerichtet" notwendigerweise eine oder mehrere Korngrenzen aus, welche die Vorteile des Einkristalls zunichte machen.

Die einkristalline Struktur wird zweckmäßig in Form von dünnen Schichten, Platten oder komplexen Formen von etwa einem Millimeter oder einem Bruchteil eines Millimeters übereinander Schicht für Schicht aufgetragen.
Wenn das Substrat z.B. durch Blindspuren, d.h. ohne Materialzufuhr, mit dem Laser oder induktiv auf eine Vorwärmtemperatur im Bereich von 600°C bis 1100°C gebracht wird und diese Temperatur z.B. während dem Aufbau aufrecht erhalten wird, werden die Spannungen im Substrat und im aufgebauten Einkristall, aber auch zwischen dem Substrat und der epitaktisch darauf aufgebauten kristallinen Struktur verringert, was zum Verhindern von Rekristallisation und Kriechen in der Kristallstruktur beiträgt.

Entspannungsglühen von Substrat und neu aufgebauter Einkristallschicht während etwa einer Stunde bei einer Temperatur im Bereich von etwa 1000°C bis 1250°C, für CMSX-4 bei ca. 1150°C und nachfolgendes langsames Abkühlen reduziert innere Spannungen, welche zur Zerstörung der einkristallinen Strukturen durch Rekristallisation und Kriechen führen könnten. Das Spannungsarmglühen könnte aber auch gleich nach dem Aufbringen der epitaktischen Schicht mit einer HF-Einrichtung erfolgen.

Das sogenannte GV-Diagramm ist für verschiedene Metalle und metallische Legierungen unterschiedlich und kann für jede Legierung berechnet oder experimentell bestimmt werden. Die Kurve L trennt im GV-Diagramm den Bereich der beiden Parameter Erstarrungsgeschwindigkeit und Temperaturgradient, in welchem die Legierung globulitisch erstarrt, von jenem, in welchem die Legierung zu einem dendritisch gerichteten Gefüge erstarrt. Eine Beschreibung und Erklärung des GV-Diagramms findet sich z.B. in Material Science Engineering Band 65 1984, in der Publikation J. D. Hunt über "Columnar to Equiangular Transition".

Ausführungsbeispiele sind in den Figuren gezeigt.

Es zeigen

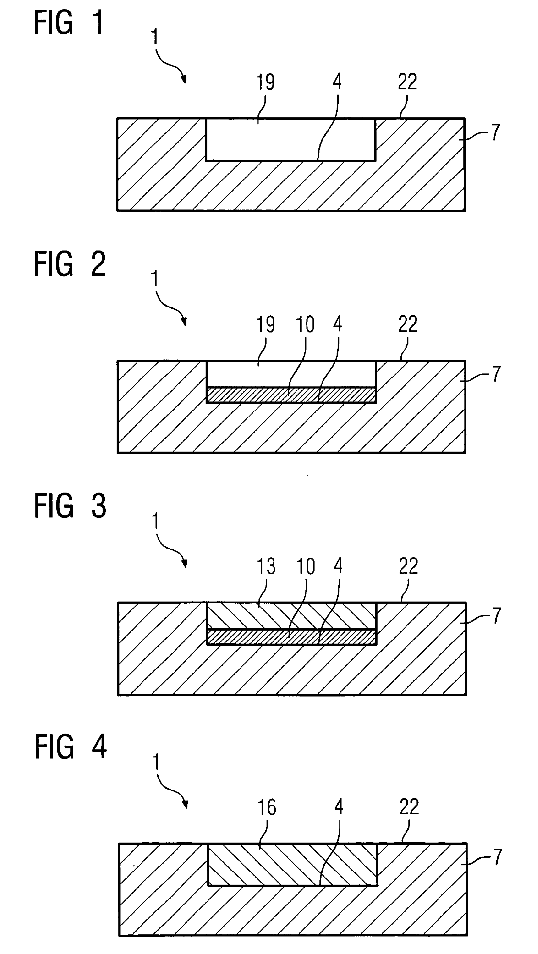

Figur 1, 2, 3, 4 verschiedene Verfahrensschritte eines erfindungsgemäßen Verfahrens.

Figur 1 zeigt ein Bauteil 1, insbesondere ein Bauteil für eine Gasturbine, wie z.B. eine Turbinenschaufel, das aus einem Substrat 7 besteht.

Das Substrat 7 ist insbesondere eine metallische Superlegierung auf Nickel- oder Kobaltbasis und weist insbesondere eine einkristalline Struktur auf.

Auf das Substrat 7 soll entweder auf der Oberfläche 22 des Bauteils oder in einer Vertiefung 19 des Bauteils 1 neues Material eingefügt werden, das eine einkristalline Struktur ähnlich oder genau wie die des Substrats 7 aufweisen soll.

Die Vertiefung 19 ist beispielsweise eine Stelle des Bauteils 1, an der Material entfernt wurde, weil dort Korrosion und/oder Risse vorlagen. Diese degradierten Bereiche wurden rückstandslos entfernt und sollen wieder aufgefüllt werden, wobei sie dieselben mechanischen Eigenschaften wie das Substrat 7 aufweisen sollen.

Figur 2 zeigt das Bauteil 1 in einem weiteren Verfahrensschritt.
Auf die Grundfläche 4 in der Vertiefung 19 oder auf der Oberfläche 22 wird erfindungsgemäss eine Zwischenschicht 10 aufgebracht.
Die Zwischenschicht 10 kann auf verschiedene Art und Weise durch ein erstes Materialauftragungsverfahren aufgebracht werden, insbesondere durch einen elektrochemischen Abscheideprozess (bspw. Elektrolyse), aber nicht durch ein Verfahren wie aus der EP 892 090 A1 bekannt.

Die Zwischenschicht 10 besteht bspw. aus Nickel und/oder Nickel/Kobalt und/oder Nickel/Kobalt/Chrom, (Hauptbestandteile des Substrats 7) wobei die Anteile von Nickel, Kobalt oder Chrom der Zwischenschicht 10 bspw. ungefähr die gleichen Verhältnisse wie die Hauptbestandteile des Materials des Substrats 7 aufweisen.
Die Zwischenschicht 10 kann aber auch die gleiche oder eine ähnliche Zusammensetzung wie das Material des Substrats 7 aufweisen.

Gegebenenfalls sind an der Grundfläche 4 Strukturfehler in der Kristallstruktur (keine Korrosion oder Degradation) der Schaufel vorhanden, die bei der Degradation entstanden sind. Bei einem Aufbringen von neuem Material besteht daher die Gefahr, dass die Strukturfehler, z. B. globulitische Körner kopiert werden, und dass das Material, das in der Vertiefung 19 einkristallin aufgebracht werden soll, nicht einkristallin wird.

Die Zwischenschicht 10 verhindert die Kopie von Strukturfehlern des Bauteils 1 an der Grundfläche 4 und ermöglicht ein epitaktisches Wachstum auf der Zwischenschicht.

Figur 3 zeigt einen weiteren Verfahrensschritt des erfindungsgemäßen Verfahrens.
Auf die Zwischenschicht 10 ist in bekannter Art und Weise mittels eines epitaktischen Materialauftragungsverfahren (bspw. Laserauftragsschweißen, wie aus der EP 892 090 A1 bekannt) neues Material 13 hinzugefügt worden, das die gleiche oder ähnliche Struktur wie das Substrat 7 des Bauteils 1 aufweist.
Beim epitaktischen Wachstum orientiert sich die Struktur des neuen Materials 13 nicht an der möglicherweise ungünstigen Struktur des Substrats 7, sondern an der Struktur der Zwischenschicht 10.

Durch die bspw. galvanische Abscheidung der Zwischenschicht 10 (ungerichtete und/oder gerichtete Mikrostruktur) ist es möglich, unabhängig von der Unterlage (polykristallin) zumindest gerichtete Strukturen zu erzeugen.
Ebenso können auch Orientierungsfehler aus DS- und SX-Strukturen durch geeignete Wahl der Abscheideparameter korrigiert werden.

Das Verfahren zur Auftragung der Zwischenschicht 10 unterscheidet sich von dem, das für die Auftragung der Schicht 13 verwendet wird.

Bei geeigneter Wahl von Material und Dicke der Zwischenschicht 10 wird der Temperatureintrag in das Substrat 7 verringert, wodurch das mit dem Prozess des epitaktischen Aufwachsens einhergehende Umschmelzen der einkristallinen Schaufel an der Oberfläche 4, 22 minimiert wird.

Die Vertiefung 19 wurde dabei beispielsweise bis zur Oberfläche 22 des Bauteils 1 in der Umgebung der Vertiefung 19 aufgefüllt.

Figur 4 zeigt einen weiteren, optionalen Verfahrensschritt des erfindungsgemäßen Verfahrens.

Durch eine Wärmebehandlung nach oder auch schon während des Laserauftragsschweißens findet eine Diffusion des Materials der Zwischenschicht 10 und der Schicht 13 bspw. auch des Substrats 7 statt, so dass die Zwischenschicht 10 in ihrer ursprünglichen Zusammensetzung teilweise oder ganz verschwindet und mit der Schicht 13 und/oder dem Substrat 7 einen Bereich 16 formt, der zumindest teilweise eine kristalline Struktur aufweist. Ebenso gleichen sich gegebenenfalls vorhandene Unterschiede in der Materialzusammensetzung der Schichten 10, 13 an.

Der Bereich 16, der die Vertiefung 19 jetzt vollständig ausfüllt, weist eine einkristalline Struktur auf und hat ähnliche oder gleiche, insbesondere mechanische, Eigenschaften wie das Substrat 7.

Bei hinreichend dünner Zwischenschicht 10 verschwindet diese ganz.

## Patentansprüche

1. Verfahren zum Herstellen von einkristallinen Strukturen, Bauteilen oder Werkstücken,
insbesondere aus metallischen Superlegierungen,
auf einem Substrat (7),
insbesondere mit einkristalliner Struktur oder einkristallinen Strukturen durch epitaktisches Aufwachsen von Schichtmaterial (13)
mittels einem ersten Materialauftragungsverfahren,
**dadurch gekennzeichnet, dass**
vor dem epitaktischen Aufwachsen auf dem Substrat (7) eine Zwischenschicht (10) mittels einem zweiten Materialauftragungsverfahren aufgebracht wird.

2. Verfahren nach Anspruch 1,
**dadurch gekennzeichnet, dass**
die Zwischenschicht (10) einer Diffusionsbehandlung unterzogen wird,
so dass sich die Zwischenschicht (10) mit dem Substrat (7) und/oder der Schicht (13) zumindest teilweise in einen Bereich (16) mit gleicher Materialzusammensetzung umwandelt.

3. Verfahren nach Anspruch 1,
**dadurch gekennzeichnet, dass**
die Zwischenschicht (10) elektrochemisch erzeugt wird.

4. Verfahren nach Anspruch 1,
**dadurch gekennzeichnet, dass**
eine Zwischenschicht (10) mit ungerichteter Mikrostruktur aufgebracht wird.

5. Verfahren nach Anspruch 1,
**dadurch gekennzeichnet, dass**
eine Zwischenschicht (10) mit gerichteter Mikrostruktur aufgebracht wird.

6. Verfahren nach Anspruch 1,
**dadurch gekennzeichnet, dass**
die Zwischenschicht (10) dort aufgebracht wird,
wo keine einkristalline oder gerichtete Struktur in dem Substrat vorhanden ist.

7. Verfahren nach Anspruch 1,
**dadurch gekennzeichnet, dass**
die verhältnismässige Zusammensetzung der Bestandteile für die Zwischenschicht (10) der verhältnismässigen Zusammensetzung der Hauptbestandteile des Substrats (7) angepasst wird.

8. Verfahren nach Anspruch 1,
**dadurch gekennzeichnet, dass**
die Materialzusammensetzung der Zwischenschicht (10) der Materialzusammensetzung des Substrats (7) zumindest ungefähr entspricht.
